# FASCICULE DE BREVET EUROPEEN

(11) **EP 3 398 826 B1**
(45) Date de publication et mention de la délivrance du brevet: **20.10.2021**
(21) Numéro de dépôt: 18170899.1
(22) Date de dépôt: 04.05.2018
(51) Int. Cl.: B61C 3/00, B61C 17/04, H05K 7/00

(54) **SYSTÈME DE REFROIDISSEMENT D'UNE CHAINE DE TRACTION POUR UN VÉHICULE DE TRANSPORT, CHAÎNE DE TRACTION ET VÉHICULE ÉLECTRIQUE DE TRANSPORT ASSOCIÉS**
KÜHLSYSTEM EINER ZUGKETTE FÜR EIN TRANSPORTFAHRZEUG, ENTSPRECHENDE ZUGKETTE UND ENTSPRECHENDES ELEKTRISCHES TRANSPORTFAHRZEUG
COOLING SYSTEM OF A POWER CHAIN FOR A TRANSPORT VEHICLE, ASSOCIATED POWER CHAIN AND ELECTRIC TRANSPORT VEHICLE

(30) Priorité: 05.05.2017 FR 1753990
(43) Date de publication de la demande: 07.11.2018
(73) Titulaire: ALSTOM Transport Technologies, 93400 Saint-Ouen (FR)
(72) Inventeur: AUDEMAR, Christophe, 65310 HORGUES (FR); LEMPEGNAT, Bruno, 64290 GAN (FR)
(74) Mandataire: Lavoix

(56) Documents cités:
- EP-A1- 0 233 577
- EP-A1- 2 308 735
- JP-A- 2009 067 087
- US-A1- 2014 211 531

## Description

La présente invention concerne un système de refroidissement pour une chaine de traction d'un véhicule électrique de transport, la chaine de traction comportant un module d'alimentation électrique d'au moins un moteur électrique, un transformateur électrique et un rhéostat de freinage.

L'invention concerne également une chaîne de traction pour un véhicule électrique de transport, la chaîne de traction comprenant un module d'alimentation électrique d'au moins un moteur électrique, un transformateur électrique, un rhéostat de freinage, et un tel système de refroidissement.

L'invention concerne également un véhicule électrique de transport, tel qu'un véhicule ferroviaire, comprenant une telle chaîne de traction, la chaîne de traction comportant un moteur électrique.

L'invention s'applique au domaine du transport, en particulier du transport ferroviaire, notamment aux véhicules de traction électriques, tels que les locomotives et les automotrices.

On connaît des documents EP 2 308 735 A1 et EP 0 233 577 A1 un rhéostat de freinage comportant une pluralité de résistances de freinage, adaptées pour dissiper l'énergie électrique résultant du freinage d'un véhicule de transport, et un dispositif de refroidissement configuré pour évacuer au moins partiellement la chaleur dissipée par le rhéostat de freinage. Le dispositif de refroidissement comporte un ventilateur configuré pour faire circuler un flux d'air à travers le rhéostat de freinage en vue de son refroidissement.

On connaît également, d'une part, un dispositif de refroidissement configuré pour évacuer au moins partiellement une chaleur dissipée par un module d'alimentation électrique, le module d'alimentation électrique étant configuré pour alimenter électriquement au moins un moteur électrique pour un véhicule électrique de transport, tel qu'un véhicule ferroviaire, et d'autre part, un dispositif de refroidissement configuré pour évacuer au moins partiellement une chaleur dissipée par un transformateur électrique, le transformateur électrique étant disposé entre le module d'alimentation électrique et un pantographe apte à être relié électriquement à une caténaire.

On connaît également du document US 2014/211531 A1 un système de refroidissement comprenant un premier dispositif de refroidissement configuré pour évacuer au moins partiellement une chaleur dissipée par un module d'alimentation et un deuxième dispositif de refroidissement configuré pour évacuer au moins partiellement une chaleur dissipée par un moteur.

Toutefois, ces différents dispositifs de refroidissement sont relativement volumineux.

La présente invention a donc pour but de proposer un système de refroidissement présentant un encombrement réduit.

A cet effet, l'invention a pour objet un système de refroidissement selon la revendication 1.

Avec le système de refroidissement selon l'invention, les premier, deuxième et troisième dispositifs de refroidissement sont tous disposés à l'intérieur d'un unique conduit de circulation d'air, ce qui permet de réduire l'encombrement du système de refroidissement selon l'invention, en comparaison avec un système de refroidissement de l'état de la technique comportant plusieurs conduits de circulation d'air, chacun étant par exemple associé à un dispositif de refroidissement respectif.

En complément facultatif, lorsque le système de refroidissement comprend en outre un unique ventilateur pour faire circuler l'air à l'intérieur dudit conduit de circulation d'air, la fiabilité du système de refroidissement est en outre améliorée, et la consommation d'énergie électrique réduite.

Suivant d'autres aspects avantageux de l'invention, le système de refroidissement comporte l'une ou plusieurs des caractéristiques optionnelles des revendications 2 à 8.

L'invention a également pour objet une chaîne de traction selon la revendication 9.

L'invention a également pour objet un véhicule électrique de transport selon la revendication 10.

Ces caractéristiques et avantages de l'invention apparaîtront à la lecture de la description qui va suivre, donnée uniquement à titre d'exemple non limitatif, et faite en référence aux dessins annexés, sur lesquels la figure unique est une représentation schématique d'un véhicule électrique de transport, tel qu'un véhicule ferroviaire, comprenant une chaîne de traction, la chaîne de traction comportant un moteur électrique, un module d'alimentation électrique d'au moins un moteur électrique, un transformateur électrique, un rhéostat de freinage, et un système de refroidissement.

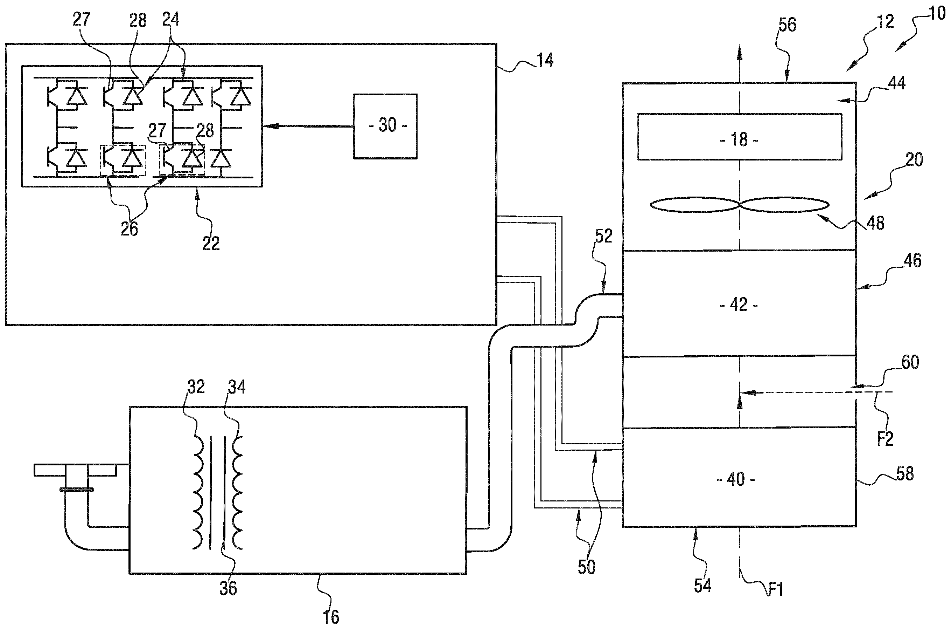

Sur la figure 1, un véhicule électrique de transport 10, tel qu'un véhicule ferroviaire, comprend une chaîne de traction 12.

La chaîne de traction 12 comprend un moteur électrique de traction et un moteur électrique auxiliaire, non représentés, un module d'alimentation électrique 14 configuré pour alimenter le ou les moteurs électriques, un transformateur électrique 16, un rhéostat de freinage 18, et un système de refroidissement 20 configuré pour refroidir au moins le module d'alimentation électrique 14, le transformateur électrique 16 et le rhéostat de freinage 18.

Le moteur électrique de traction est connu en soi, et permet d'entrainer en rotation des roues du véhicule pour le déplacement de ce dernier. Le moteur électrique de traction est par exemple un moteur électrique alternatif, tel qu'un moteur triphasé.

Le moteur électrique auxiliaire est également connu en soi, et est par exemple un moteur électrique alternatif.

Le module d'alimentation électrique 14 est connu en soi, et comprend un convertisseur d'énergie électrique 22. Le convertisseur d'énergie électrique 22 est configuré par exemple pour convertir une énergie électrique alternative issue d'un réseau d'alimentation électrique en une autre énergie électrique alternative délivrée au moteur électrique. Le convertisseur d'énergie électrique 22 comporte, comme connu en soi, plusieurs bras de commutation 24, chaque bras de commutation 24 étant par exemple associé à une phase respective de l'énergie électrique alternative délivrée en sortie du convertisseur et comportant plusieurs interrupteurs 26 connectés en série. Chaque interrupteur 26 est par exemple formé d'un transistor 27 et d'une diode 28 connectée en antiparallèle du transistor 27. Le transistor 27 est par exemple un transistor bipolaire à grille isolée, également appelé IGBT (de l'anglais *Insulated Gate Bipolar Transistor).*

Le module d'alimentation électrique 14 comprend également un dispositif de commande 30 configuré pour commander le convertisseur d'énergie électrique 22, en particulier pour commander la commutation des interrupteurs 26 dudit convertisseur.

Le transformateur électrique 16 est, par exemple, disposé entre le module d'alimentation électrique 14 et un pantographe, non représenté, apte à être relié électriquement à une caténaire, afin de relier électriquement le véhicule électrique de transport 10 à un réseau électrique d'alimentation.

Le transformateur électrique 16 comprend, comme connu en soi, un enroulement primaire 32 apte à être relié électriquement au réseau d'alimentation via le pantographe, et un enroulement secondaire 34 apte à être relié électriquement au module d'alimentation électrique 14, ainsi qu'un noyau 36 disposé entre l'enroulement primaire 32 et l'enroulement secondaire 34.

Le rhéostat de freinage 18 est également connu en soi, et comprend une pluralité de résistances de freinage, non représentées, adaptées pour dissiper par effet Joule l'énergie électrique résultant d'un freinage du véhicule électrique de transport 10. Les résistances de freinage sont généralement en forme de bandes.

Le système de refroidissement 20 est également appelé système de dissipation thermique, le système de refroidissement 20 étant configuré pour évacuer au moins partiellement une chaleur dissipée par le module d'alimentation électrique 14, le transformateur électrique 16 et le rhéostat de freinage 18 de la chaine de traction 12.

Le système de refroidissement 20 comprend un premier dispositif de refroidissement 40 configuré pour évacuer au moins partiellement une chaleur dissipée par le module d'alimentation électrique 14, un deuxième dispositif de refroidissement 42 configuré pour évacuer au moins partiellement une chaleur dissipée par le transformateur électrique 16, et un troisième dispositif de refroidissement 44 configuré pour évacuer au moins partiellement une chaleur dissipée par le rhéostat de freinage 18.

Selon l'invention, les premier 40, deuxième 42 et troisième 44 dispositifs de refroidissement sont disposés à l'intérieur d'un unique conduit 46 de circulation d'air, le système de refroidissement 20 comprenant ledit conduit de circulation d'air 46 et au moins un ventilateur 48 configuré pour générer un flux d'air dans ledit conduit de circulation d'air 46.

Le système de refroidissement 20 comprend de préférence un unique ventilateur 48 configuré pour générer le flux d'air dans le conduit de circulation d'air 46. Ceci permet alors de réduire la consommation d'énergie électrique du système de refroidissement 20, et est également de réduire la probabilité d'une défaillance de la ventilation d'air par rapport à un système à plusieurs ventilateurs, où chaque ventilateur est susceptible de tomber en panne.

Les premier 40, deuxième 42 et troisième 44 dispositifs de refroidissement sont de préférence disposés dans cet ordre et suivant le sens de circulation de l'air à l'intérieur du conduit de circulation d'air 46.

Le premier dispositif de refroidissement 40 comporte un premier échangeur thermique, et est thermiquement relié au module d'alimentation électrique 14 via un premier circuit 50. Le premier échangeur thermique est par exemple un échangeur air/eau, de préférence un échangeur air/eau glycolée, et le premier circuit 50 est alors configuré pour faire circuler de l'eau, telle que de l'eau glycolée, entre le module d'alimentation 14 et le premier dispositif de refroidissement 40. Dans cet exemple, le module d'alimentation électrique 14 comporte des plaques à eau, non représentées, contre lesquelles sont disposés les composants du module d'alimentation électrique 14 qui dissipent le plus de chaleur, notamment les transistors 27. L'eau contenue dans le premier circuit 50 permet alors d'évacuer la chaleur dissipée par ces composants jusqu'à l'échangeur air/eau où le flux d'air circulant dans le conduit de circulation d'air 46 permet alors de refroidir l'eau contenue dans le premier circuit 50, afin que celle-ci puisse ensuite à nouveau évacuer la chaleur dissipée par les composants du module d'alimentation électrique 14 lors de son fonctionnement.

Le deuxième dispositif de refroidissement 42 comporte un deuxième échangeur thermique, et est thermiquement relié au transformateur électrique 16 via un deuxième circuit 52. Le deuxième échangeur thermique est par exemple un échangeur air/huile, et le deuxième circuit 52 est alors configuré pour faire circuler de l'huile entre le transformateur électrique 16 et le deuxième dispositif de refroidissement 42. Dans cet exemple, l'enroulement primaire 32, l'enroulement secondaire 34 et le noyau 36 du transformateur électrique sont disposés dans un bain d'huile. L'huile contenue dans le deuxième circuit 52 permet alors d'évacuer la chaleur dissipée par l'enroulement primaire 32, l'enroulement secondaire 34 et le noyau 36 du transformateur électrique jusqu'à l'échangeur air/huile où le flux d'air circulant dans le conduit de circulation d'air 46 permet alors de refroidir l'huile contenue dans le deuxième circuit 52, afin que celle-ci puisse ensuite à nouveau évacuer la chaleur dissipée par le transformateur électrique 16 lors de son fonctionnement.

Le troisième dispositif de refroidissement 44 comporte des moyens, non représentés, de maintien des résistances de freinage à l'intérieur du conduit de circulation d'air 46, afin que le flux d'air circulant dans ledit conduit évacue la chaleur dissipée par ces résistances de freinage lors d'un freinage du véhicule de transport 10.

En complément facultatif, le troisième dispositif de refroidissement 44 comporte en outre un ou plusieurs déflecteurs d'air, non représentés, pour diriger davantage le flux d'air vers les résistances du rhéostat de freinage 18.

Le conduit de circulation d'air 46 comporte une entrée d'air 54 et une sortie d'air 56, l'entrée d'air 54 et la sortie d'air 56 étant disposées chacune en une extrémité respective dudit conduit 46, une paroi latérale 58 entre l'entrée d'air 54 et la sortie d'air 56.

En complément facultatif, le conduit de circulation d'air 46 comporte en outre au moins un orifice auxiliaire 60 d'entrée d'air, chaque orifice auxiliaire 60 étant ménagé dans la paroi latérale 58. L'orifice auxiliaire d'entrée d'air 60 est de préférence disposé entre les premier 40 et deuxième 42 dispositifs de refroidissement.

En complément facultatif encore, le conduit de circulation d'air 46 comporte plusieurs orifices auxiliaires d'entrée d'air 60, chacun étant de préférence disposé entre deux dispositifs de refroidissement successifs.

En complément facultatif encore, le conduit de circulation d'air 46 comporte une grille d'équilibrage, non représentée, agencée en entrée du ou de chaque orifice auxiliaire d'entrée d'air 60, afin d'ajuster le débit d'air pénétrant à l'intérieur du conduit de circulation d'air 46 via le ou les orifices auxiliaires d'entrée d'air 60.

Le ou chaque ventilateur 48 est connu en soi. Chaque ventilateur 48 est de préférence disposé à l'intérieur du conduit de circulation d'air 46. En variante, non représentée, au moins un ventilateur 48 est disposé à l'extérieur du conduit de circulation d'air 46, tout en faisant circuler le flux d'air à l'intérieur dudit conduit de circulation 46.

Au moins un ventilateur 48 est de préférence disposé à l'intérieur du conduit de circulation d'air 46 entre le troisième dispositif de refroidissement 44 et l'un des premier 40 et deuxième 42 dispositifs de refroidissement.

Le ou les ventilateurs 48 permettent alors de faire circuler un flux d'air à l'intérieur du conduit de circulation d'air 46 selon la flèche F1, afin d'évacuer la chaleur dissipée par le module d'alimentation électrique 14, le transformateur électrique 16 et le rhéostat de freinage 18 via les premier 40, deuxième 42 et troisième 44 dispositifs de refroidissement disposés à l'intérieur de l'unique conduit de circulation d'air 46.

En complément facultatif, le flux d'air circule de préférence depuis le premier dispositif de refroidissement 40, jusqu'au troisième dispositif de refroidissement 44 via le deuxième dispositif de refroidissement 42, les premier et deuxième et troisième dispositifs de refroidissement 40, 42, 44 étant alors disposés dans cet ordre à l'intérieur de l'unique conduit de circulation d'air 46. Le flux d'air évacuant la chaleur dissipée par le rhéostat de freinage 18 est alors rejeté directement vers l'extérieur du conduit de circulation d'air 46, ce qui permet d'éviter un endommagement du ou des ventilateurs 48.

Autrement dit, le ou les ventilateurs 48 sont alors de préférence disposés en amont du troisième dispositif de refroidissement 44 selon le sens de circulation de l'air à l'intérieur du conduit de circulation 46.

Lorsque le conduit de circulation d'air 46 comporte en complément facultatif au moins un orifice auxiliaire d'entrée d'air 60, de l'air pénètre latéralement à l'intérieur du conduit de circulation d'air 46, selon la flèche F2. Cette entrée auxiliaire d'air, disposée par exemple entre le premier dispositif de refroidissement 40 et le deuxième dispositif de refroidissement 42, en amont du ou des ventilateurs 48, permet alors de diminuer la perte de charge pour le ou les ventilateurs 48.

Le ou les orifices auxiliaires d'entrée d'air 60 permettent également, même avec un seul ventilateur 48, d'ajuster le débit d'air en entrée de chaque dispositif de refroidissement 40, 42, 44.

On conçoit ainsi que le système de refroidissement 20 selon l'invention présente un encombrement réduit de par l'unique conduit de circulation d'air 46 à l'intérieur duquel sont disposés les premier, deuxième et troisième dispositifs de refroidissement 40, 42, 44.

## Revendications

1. Système de refroidissement (20) pour une chaine de traction (12) d'un véhicule électrique de transport (10), la chaine de traction (12) comportant un module (14) d'alimentation électrique d'au moins un moteur électrique, un transformateur électrique (16) et un rhéostat de freinage (18),
le système de refroidissement (20) comprenant :
- un premier dispositif de refroidissement (40) configuré pour évacuer au moins partiellement une chaleur dissipée par le module d'alimentation électrique (14),
- un deuxième dispositif de refroidissement (42) configuré pour évacuer au moins partiellement une chaleur dissipée par le transformateur électrique (16),
- un troisième dispositif de refroidissement (44) configuré pour évacuer au moins partiellement une chaleur dissipée par le rhéostat de freinage (18),
- les premier (40), deuxième (42) et troisième (44) dispositifs de refroidissement étant disposés à l'intérieur d'un unique conduit (46) de circulation d'air, le système de refroidissement (20) comprenant ledit conduit de circulation d'air (46) et au moins un ventilateur (48) configuré pour générer un flux d'air dans ledit conduit de circulation d'air (46).

2. Système de refroidissement (20) selon la revendication 1, dans lequel le système de refroidissement (20) comprend un unique ventilateur (48) configuré pour générer un flux d'air dans le conduit de circulation d'air (46).

3. Système de refroidissement (20) selon la revendication 1 ou 2, dans lequel le premier dispositif de refroidissement (40) comporte un premier échangeur thermique,
le premier échangeur thermique étant de préférence un échangeur air/eau.

4. Système de refroidissement (20) selon l'une quelconque des revendications précédentes, dans lequel le deuxième dispositif de refroidissement (42) comporte un deuxième échangeur thermique,
le deuxième échangeur thermique étant de préférence un échangeur air/huile.

5. Système de refroidissement (20) selon l'une quelconque des revendications précédentes, dans lequel au moins un ventilateur (48) est disposé à l'intérieur du conduit de circulation d'air (46) entre le troisième dispositif de refroidissement et l'un des premier (40) et deuxième (42) dispositifs de refroidissement.

6. Système de refroidissement (20) selon l'une quelconque des revendications précédentes, dans lequel le conduit de circulation d'air (46) comporte une entrée d'air (54) et une sortie d'air (56), l'entrée d'air (54) et la sortie d'air (56) étant disposées chacune en une extrémité respective dudit conduit (46), une paroi latérale (58) entre l'entrée d'air (54) et la sortie d'air (56), et le conduit de circulation (46) comporte en outre au moins un orifice auxiliaire d'entrée d'air (60), chaque orifice auxiliaire (60) étant ménagé dans la paroi latérale (58).

7. Système de refroidissement (20) selon la revendication 6, dans lequel un orifice auxiliaire d'entrée d'air (60) est disposé entre les premier (40) et deuxième (42) dispositifs de refroidissement.

8. Système de refroidissement (20) selon l'une quelconque des revendications précédentes, dans lequel le premier dispositif de refroidissement (40), le deuxième dispositif de refroidissement (42) et le troisième dispositif de refroidissement (44) sont disposés dans cet ordre et suivant le sens de circulation de l'air à l'intérieur du conduit de circulation d'air (46).

9. Chaine de traction (12) pour un véhicule électrique de transport (10), tel qu'un véhicule ferroviaire, la chaine de traction (12) comprenant :
- un module (14) d'alimentation électrique d'au moins un moteur électrique,
- un transformateur électrique (16),
- un rhéostat de freinage (18), et
- un système de refroidissement (20),
**caractérisé en ce que** le système de refroidissement (20) est selon l'une quelconque des revendications précédentes.

10. Véhicule électrique de transport (10), tel qu'un véhicule ferroviaire, comprenant une chaîne de traction (12), la chaîne de traction (12) comportant un moteur électrique,
**caractérisé en ce que** la chaîne de traction (12) est selon la revendication précédente.

## Patentansprüche

1. Kühlsystem (20) für einen Antriebsstrang (12) eines elektrischen Transportfahrzeugs (10), wobei der Antriebsstrang (12) ein Modul (14) zur elektrischen Versorgung mindestens eines Elektromotors, einen elektrischen Transformator (16) und einen Bremsrheostat (18) aufweist,
wobei das Kühlsystem (20) umfasst:
- eine erste Kühlvorrichtung (40), die ausgebildet ist, eine von dem elektrischen Versorgungsmodul (14) abgegebene Wärme zumindest teilweise abzuführen,
- eine zweite Kühlvorrichtung (42), die ausgebildet ist, eine von dem elektrischen Transformator (16) abgegebene Wärme zumindest teilweise abzuführen,
- eine dritte Kühlvorrichtung (44), die ausgebildet ist, eine vom Bremsrheostat (18) abgegebene Wärme zumindest teilweise abzuführen,
- wobei die erste (40), zweite (42) und dritte (44) Kühlvorrichtung im Inneren eines einzigen Luftströmungskanals (46) angeordnet sind und das Kühlsystem (20) den Luftströmungskanal (46) und mindestens ein Gebläse (48) umfasst, das ausgebildet ist, einen Luftstrom in dem Luftströmungskanal (46) zu erzeugen.

2. Kühlsystem (20) nach Anspruch 1, bei dem das Kühlsystem (20) ein einziges Gebläse (48) umfasst, das ausgebildet ist, einen Luftstrom in dem Luftströmungskanal (46) zu erzeugen.

3. Kühlsystem (20) nach Anspruch 1 oder 2, bei dem die erste Kühlvorrichtung (40) einen ersten Wärmetauscher umfasst,
wobei der erste Wärmetauscher vorzugsweise ein Luft/Wasser-Wärmetauscher ist.

4. Kühlsystem (20) nach einem beliebigen der vorhergehenden Ansprüche, wobei die zweite Kühlvorrichtung (42) einen zweiten Wärmetauscher aufweist,
wobei der zweite Wärmetauscher vorzugsweise ein Luft/Öl-Wärmetauscher ist.

5. Kühlsystem (20) nach einem beliebigen der vorhergehenden Ansprüche, bei dem mindestens ein Gebläse (48) innerhalb des Luftströmungskanals (46) zwischen der dritten Kühlvorrichtung und einer der ersten (40) und zweiten (42) Kühlvorrichtungen angeordnet ist.

6. Kühlsystem (20) nach einem beliebigen der vorhergehenden Ansprüche, bei dem der Luftströmungskanal (46) einen Lufteinlass (54) und einen Luftauslass (56) aufweist und der Lufteinlass (54) und der Luftauslass (56) jeweils an einem entsprechenden Ende des Kanals (46) angeordnet sind, wobei eine Seitenwand (58) zwischen dem Lufteinlass (54) und dem Luftauslass (56) vorhanden ist und der Strömungskanal (46) außerdem mindestens eine Hilfslufteinlassöffnung (60) aufweist, wobei jede Hilfsöffnung (60) in der Seitenwand (58) vorgesehen ist.

7. Kühlsystem (20) nach Anspruch 6, bei dem eine Hilfslufteinlassöffnung (60) zwischen der ersten (40) und der zweiten (42) Kühlvorrichtung angeordnet ist.

8. Kühlsystem (20) nach einem beliebigen der vorhergehenden Ansprüche, bei dem die erste Kühlvorrichtung (40), die zweite Kühlvorrichtung (42) und die dritte Kühlvorrichtung (44) in dieser Reihenfolge und entlang der Richtung des Luftstroms im Inneren des Luftströmungskanals (46) angeordnet sind.

9. Antriebsstrang (12) für ein elektrisches Transportfahrzeug (10), wie ein Schienenfahrzeug, wobei der Antriebsstrang (12) umfasst:
- ein Modul (14) zur elektrischen Versorgung mindestens eines Elektromotors,
- einen elektrischen Transformator (16),
- einen Bremsrheostat (18), und
- ein Kühlsystem (20),
**dadurch gekennzeichnet, dass** das Kühlsystem (20) nach einem beliebigen der vorhergehenden Ansprüche ausgebildet ist.

10. Elektrisches Transportfahrzeug (10), wie ein Schienenfahrzeug, mit einem Antriebsstrang (12), wobei der Antriebsstrang (12) einen Elektromotor aufweist,
**dadurch gekennzeichnet, dass** der Antriebsstrang (12) entsprechend dem vorhergehenden Anspruch ausgebildet ist.

## Claims

1. A cooling system (20) for a drive train (12) of an electric transport vehicle (10), the drive train (12) comprising a power supply module (14) for at least one electric motor, an electrical transformer (16) and a braking rheostat (18),
the cooling system (20) comprising:
- a first cooling device (40) configured to at least partially remove heat dissipated by the power supply module (14),
- a second cooling device (42) configured to at least partially remove heat dissipated by the electrical transformer (16),
- a third cooling device (44) configured to at least partially remove heat dissipated by the braking rheostat (18),
- the first (40), second (42) and third (44) cooling devices being disposed within a single air flow duct (46), the cooling system (20) comprising said air flow duct (46) and at least one fan (48) configured to generate an air flow in said air flow duct (46).

2. The cooling system (20) of claim 1, wherein the cooling system (20) comprises a single fan (48) configured to generate an air flow in the air flow duct (46).

3. The cooling system (20) of claim 1 or 2, wherein the first cooling device (40) comprises a first heat exchanger,
the first heat exchanger preferably being an air/water exchanger.

4. The cooling system (20) according to any one of the preceding claims, wherein the second cooling device (42) comprises a second heat exchanger,
the second heat exchanger preferably being an air/oil exchanger.

5. The cooling system (20) according to any one of the preceding claims, wherein at least one fan (48) is disposed within the air flow duct (46) between the third cooling device and one of the first (40) and second (42) cooling devices.

6. The cooling system (20) according to any one of the preceding claims, wherein the air circulation duct (46) comprises an air inlet (54) and an air outlet (56), the air inlet (54) and the air outlet (56) each being disposed at a respective end of said duct (46), a side wall (58) between the air inlet (54) and the air outlet (56), and the circulation duct (46) further comprises at least one auxiliary air inlet port (60), each auxiliary port (60) being formed in the side wall (58).

7. The cooling system (20) according to claim 6, wherein an auxiliary air inlet port (60) is disposed between the first (40) and second (42) cooling devices.

8. The cooling system (20) according to any one of the preceding claims, wherein the first cooling device (40), the second cooling device (42) and the third cooling device (44) are arranged in that order and along the direction of air flow within the air flow duct (46).

9. A drive train (12) for an electric transport vehicle (10), such as a railway vehicle, the drive train (12) comprising:
- a module (14) for supplying power to at least one electric motor,
- an electrical transformer (16),
- a braking rheostat (18), and
- a cooling system (20),
**characterized in that** the cooling system (20) is according to any of the preceding claims.

10. An electric transport vehicle (10), such as a railway vehicle, comprising a drive train (12), the drive train (12) comprising an electric motor,
**characterized in that** the drive train (12) is according to the preceding claim.
